(19) **Europäisches Patentamt**
**European Patent Office**
**Office européen des brevets**

(11) **EP 2 599 274 B1**

(12) **EUROPEAN PATENT SPECIFICATION**

(45) Date of publication and mention
of the grant of the patent:
**27.08.2014 Bulletin 2014/35**

(51) Int Cl.:
**H04L 27/36** (2006.01)     **H03F 1/32** (2006.01)

(21) Application number: **10735294.0**

(86) International application number:
**PCT/EP2010/060851**

(22) Date of filing: **27.07.2010**

(87) International publication number:
**WO 2012/013218 (02.02.2012 Gazette 2012/05)**

(54) **Method for predistortion in a communication system**

Vorverzerrungsverfahren in einem Kommunikationssystem

Procédé de prédistorsion dans un système de communication

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**05.06.2013 Bulletin 2013/23**

(73) Proprietor: **Intracom S.A. Telecom Solutions**
**19002 Peania, Athens (GR)**

(72) Inventors:
 • **DEHOS, Cédric**
  **F-29100 Douarnenez (FR)**

 • **KALOGIROS, Dimitris**
  **GR-19013 Attikis (GR)**
 • **PANAYIOTOPOULOS, Ilias**
  **GR-15342 Athens (GR)**
 • **ROSSON, Patrick**
  **F-38240 Meylan (FR)**
 • **ZELENY, Jan**
  **100 10Praha 10 (CZ)**

(74) Representative: **Samuelides, Emmanuel**
 **Leof. Alexandras 43**
 **114 73 Athens (GR)**

(56) References cited:
 **EP-A1- 2 117 115**

**Description**

The present application relates to the field of communication systems and can be applied to various communication standards, in particular to those using Orthogonal Frequency Division Multiplexing (OFDM) such as 802.11a, 802.11n, 802.16e, 3G-LTE, etc.

From a signal processing theoretical point of view, the communication systems are generally assumed to be linear. However, in practice, some components comprised in a communication system, either at the transmitter side, such as a power amplifier, or at the receiver side, such as a low noise amplifier (LNA), may exhibit non-linear characteristics. In such instance, the waveform of a signal transmitted by the transmitter and received by the receiver, is distorted if at least one of these components does not operate in its linear range. Due to this distortion, the reception of the transmitted symbols is degraded and the bit error rate (BER) is thus quite high. Furthermore, in case the communication system uses a plurality of frequency bands e.g. in an OFDM system a distortion of the signal in one frequency band may create a spectral regrowth in an adjacent frequency band (inter-band interference).

The problem of non-linear characteristics is particularly acute in OFDM systems since multi-carrier signals generally exhibit a high PAPR (Peak-to-Average-Power Ratio), in other words the signal waveforms have large amplitude variations. As the power amplifier is typically non-linear for large amplitudes, it may be necessary to decrease the output power in order to reduce the distortion. However, such reduction of the output power is detrimental to the signal-to-noise ratio at the reception. Alternatively, an A-class amplifier may be used at the expense of higher energy consumption and manufacturing costs.

For the reasons stated above, it is therefore essential to remove non-linear effects at large signal amplitudes.

The mitigation of non-linear effects in OFDM communication systems has been extensively investigated.

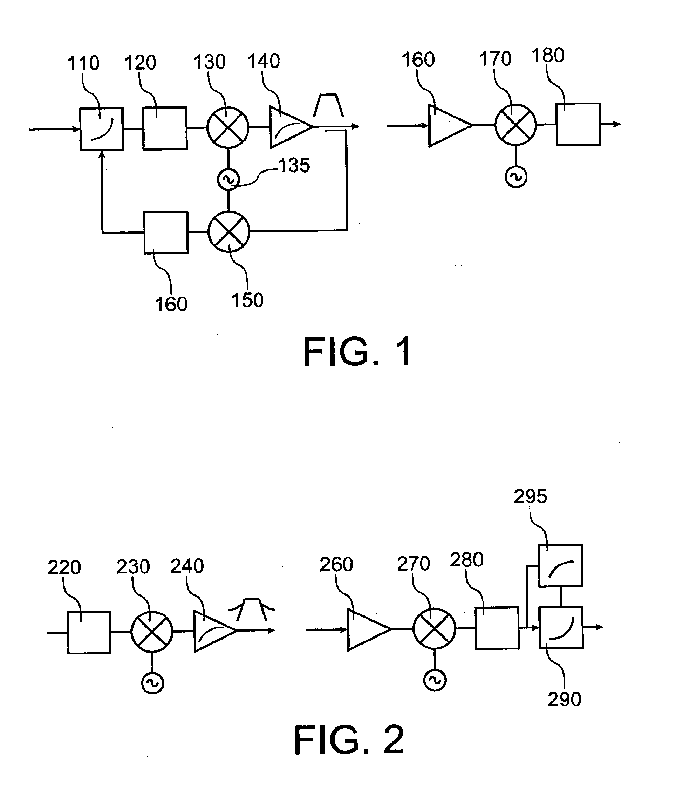

A first method for mitigating non-linear effects has been disclosed in US-A-6304140, where it is proposed to predistort the digital signal prior to its amplification. More specifically, a communication system implementing such a method is shown in Fig. 1. The signal at the output of the preamplifier 140 is down-converted to baseband by the mixer 150 and the baseband signal is sampled and digitized in ADC 160. The digital values thus obtained address a look-up table 110 in which are stored pre-measured calibration data. These data represent predistorted amplitude values which are converted into an analogue signal by DAC converter 120, which is then up-converted by mixer 130 and amplified by preamplifier 140.

The look-up table may be either static or dynamic. In the latter case, the calibration is carried out at regular intervals and the calibration data are updated accordingly.

The predistortion method described above only mitigates non-linear characteristics of the amplifier and does not take into account non-linear effects possibly occurring downstream, *e.g.* at the receiving side. Furthermore, this predistortion method is complex, especially in case of adaptive predistortion, and therefore does not lend itself to an implementation in a mobile terminal, *i.e.* for an uplink. Even if implemented in a base station, *i.e.* for a downlink, the provision of additional components (fast feedback loop) increases the manufacturing costs of the transmitter.

A second method for mitigating non-linear effects has been disclosed in US2008/0032631, where it is proposed to compensate for non-linear effects occurring at the transmitter and/or the receiver.

More precisely, Fig. 2 represents a communication system implementing this method. The transmitter comprises an ADC converter, 220, a mixer, 230, and a preamplifier 240. At the receiving side, the signal is amplified in a low noise amplifier (LNA), 260, downconverted by the mixer 270 before being sampled and digitized in the DAC converter 280. The non linear effects incurred by the signal are estimated in module 295 (*e.g.* from a training sequence) and compensated for in module 290.

It is nevertheless difficult to compensate for the clipping of a signal or a saturation of the preamplifier after it has occurred. In such instance, the first method achieves better results.

EP 2 117 115 discloses a method for mitigating a nonlinear effect affecting an OFDM communication system, which includes a transmitter, a transmission channel and a receiver. The method comprises: i) estimating at the receiver a set of parameters describing said nonlinear effect, from a sequence received at the receiver and distorted by said nonlinear effect; ii) transmitting the estimated values of said parameters back to said transmitter over a return channel; and iii) predistorting at the transmitter a signal to be sent to the receiver by using said estimated values of said parameters.

There is therefore a need for a method mitigating the non-linear effects occurring in a communication system, both at the transmitter and the receiver, which does not require a complex implementation at the transmitter side and which can prevent clipping or saturation in a component.

The present invention is defined in the appended independent claims. Various advantageous embodiments are given in the dependent claims.

The present invention will be better understood from the description of the following embodiments, by way of illustration and in no way limitative thereto:

Fig. 1 represents a communication system implementing a known non-linearity predistortion method at the transmitting side;

Fig. 2 represents a communication system implementing a non-linearity compensation method at the receiving side;

Fig. 3 schematically shows an example of a communication system implementing a digital predistortion method according the invention;

Fig. 4A illustrates the AM-AM characteristics of a non-linear amplifier;

Fig. 4B illustrates a predistortion function for predistorting the amplitude of a signal prior to its amplification by the amplifier of fig. 4A;

Fig. 4C illustrates the AM-AM characteristics of the power amplifier of Fig. 4A when linearized by the predistortion function of Fig. 4B.

We will consider in the following a communication system comprising a transmitter at a source terminal, a transmission channel and a receiver at a destination terminal. The term "terminal" should be understood here in its broadest sense and may encompass either a base station or a relay station. The communication system comprises at least one non-linear component located at the transmitter of the source terminal or at the receiver of the destination. The invention also applies to a communication system comprising a plurality of non-linear components distributed along the transmission/reception chain. Examples of non-linear components are power amplifiers, mixers, variable gain amplifiers, low noise amplifiers, etc.

The invention equally applies to a communication system using a relayed channel. In such instance, the communication system may be embodied by the transmitter and the relay (acting as receiver) or the relay (acting as transmitter) and the receiver. Alternatively, if the relay is of the type "*Amplify and Forward*", namely if the relay simply receives the signal, amplifies it and resends it, the non-linear effects occurring in the overall relayed channel may be taken into account by the method according to the invention.

For the sake of illustration only and without prejudice of generalization, we will assume in the following that the communication system involves only one non-linear component located at the transmitter of the source terminal, namely a power amplifier. The man skilled in the art will nevertheless understand that the present method equally applies to other linear effects occurring at the transmitter and/or the receiver and/or over the channel (relayed or not).

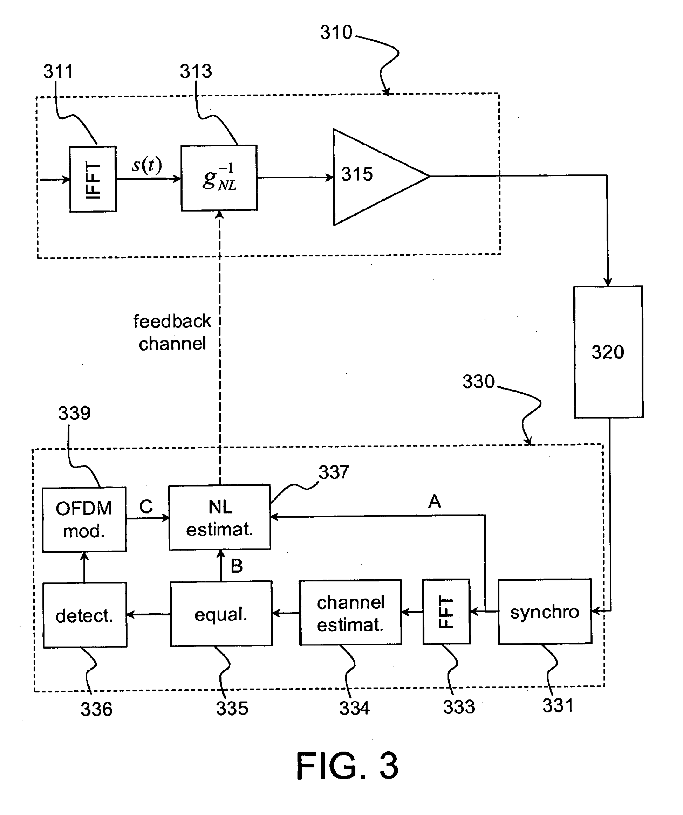

More specifically, Fig. 3 illustrates an example of an OFDM communication system applying a predistortion method according to the invention.

The illustrated OFDM communication system comprises a transmitter, 310, a transmission channel, 320, and a receiver, 330. The transmitter may comprise various coding and modulation means (not shown), depending upon the standard used, to generate modulation symbols from information symbols. The modulation symbols are then serial-to-parallel converted (not shown) into blocks which are transformed into the time domain by IFFT 311, as conventionally known from the prior art. It will also be understood than an OFDM symbol can be represented either by a block of modulation symbols in the frequency domain or by a sequence of samples in the time domain.

This signal obtained in the time domain is predistorted by predistorting means 313 before being amplified in power amplifier 315 and sent over the transmission channel 320.

At the receiving side, the signal is subjected to various processing steps according to the standard used. Typically, the receiver 330 may comprise a low noise amplifier (not shown), a mixer (not shown) for baseband down-conversion, an analogue-to-digital converter (not shown), synchronization means, 331, *e.g.* for determining the beginning of a frame or a sequence of symbols, an FFT module, 333, for transforming the OFDM symbols into the frequency domain, channel estimation means, 334, for estimating the channel coefficients, as known in the art. The channel coefficients are provided to the equalizer 335 for equalizing the received symbols. Finally, the information symbols are obtained from the symbols thus equalized via detection means 336.

Two variants can be envisaged for the channel estimation.

According to a first variant, a training sequence is appended as a preamble at the beginning of the frame of OFDM symbols carrying the payload. This training sequence is known by the receiver and designed to exhibit a low PAPR. Because of its low PAPR, the training sequence experiences little non-linear effect (at least no NL effect due to saturation) and the channel coefficients can be estimated.

The training sequence can be generated directly in the time domain and inserted just after the IFFT module 311. Alternatively, it can be generated in the frequency domain, inserted before the IFFT module 311 and thereby converted into the time domain. If defined in the frequency domain, the training sequence may be constituted by a plurality of OFDM symbols, for example OFDM pilot symbols. We understand here by OFDM pilot symbol an OFDM symbol which has only pilot tones, *i.e.* an OFDM symbol for which the modulation symbols modulating the various sub-carriers are known to the receiver.

According to a second variant, pilot tones may be interspersed with modulation data in OFDM symbols. Such OFDM symbols comprising pilot tones are subjected to predistortion in 313, so as to be "linearized" at the receiver side. The channel coefficients can be estimated from the pilot tones thus received.

As explained further below in more detail, it is proposed to estimate the non-linear characteristics of the components located upstream the input of the non-linearity estimation means, 337, by using a training sequence as defined above.

More specifically, the non-linearity estimation means 337 may estimate said non-linear characteristics from a training sequence as output by synchronisation means, 331, and FFT module, 333, before it is equalized (option represented by A).

Alternatively, if the training sequence is a sequence of pilot OFDM symbols, the non-linearity estimation means 337 may estimate said non-linear characteristics from said pilot OFDM symbols as output by the equalizer 335 (option represented by B).

Further alternatively, the estimation of the non-linearity can be decision-aided. In such instance, the training sequence is still a sequence of OFDM symbols, but the non-linearity estimation means 337 estimates said non-linear characteristics by OFDM re-modulating, in OFDM modulator 339, the information symbols (option presented by C) detected in 336 from the equalized OFDM symbols. The OFDM modulator 339 maps the detected information symbols into modulation symbols, S/P converts them into parallel blocks and transforms the blocks thus obtained back in the time domain. It is emphasized that the information symbols should be error-free. This can be checked by using an error correcting code (ECC) or a Cyclic Redundancy Check (CRC), well known in the art.

The non-linear characteristics are estimated as a list of parameters which is sent in digital form to the transmitter and provided to the predistortion means. It should be understood that, if $g_{NL}$ is a function describing the non-linear effect, the list of parameters may define $g_{NL}$ or its inverse, $g_{NL}^{-1}$, called the predistortion function, used for predistorting the signal. The predistortion function can be calculated at the receiving side or at the transmitting side. In both cases, the predistortion function compensates for the non-linear effect induced by all the components located between the predistortion means and the non-linearity estimation means, 337.

It will be appreciated that the estimation of the non linear-effect and the calculation of the predistortion function can be entirely carried out at the receiving side. This is particularly advantageous in case the transmitter is a mobile terminal since the predistortion itself does not require a complex implementation.

The estimation of the non linear effect can be performed periodically, or when the BER (Bit Error Rate) exceeds a given threshold, or on request from the transmitter, or when the transmission power has changed (*e.g.* due to a new power allocation). The parameters can be sent as a message at the physical level or embedded in a PDU (Protocol Data Unit) of higher level.

Where the standard already provides for a message from the receiver to the transmitter, *i.e.* an uplink message (if the source is a mobile terminal and the destination is a base station) or a downlink message (if the source is a base station and the destination is a mobile terminal), and if bits are available in this message, the parameters are preferably sent by using these bits. Otherwise, a specific predistortion information message coding these parameters can be designed. Examples of predistortion information messages for some standards are given further below.

In general, the estimation of the non-linear effect is obtained from a training sequence.

According to an embodiment of the invention, the non-linear effect can be estimated from a sequence of *N* training OFDM symbols $P_0,..., P_{N-1}$. These training symbols may be defined either in the frequency domain or in the time domain.

The training sequence is defined as:

$$\lambda_0 P_0 \, , \, \lambda_1 P_0 \, , \, \ldots \, , \, \lambda_{N-1} P_0. \tag{1}$$

where $P_0$ is a pilot OFDM symbol and $\lambda_0,..,\lambda_{N-1}$ are scalar or complex values of distinct amplitudes. Preferably, the amplitudes thereof are chosen to span the whole range of the preamplifier. More preferably, $\lambda_n = a^n e^{i\varphi_n}$ for $0 \leq n \leq N$-1 where $a > 1$ is a scalar value.

As the receiver knows these symbols, it can estimate how they are distorted. Whereas channel estimation accounts for the linear response of the transmission channel, the non-linear estimation accounts for the non-linear distortion of the transmitted signal. Non-linear estimation and channel estimation can be performed in two distinct steps or in one single step. When they are preformed in two distinct steps, the non-linear estimation can be carried directly on the training sequence or on the equalized training sequence.

Whatever the variant, the non-linear effect can be estimated in the time domain or in the frequency domain according to one of the methods already described in US2008/0032631.

More specifically, if we denote s the signal at the input of power amplifier 315 and $s_1$ the signal at its output, prior to be sent over the transmission channel, we have, in the time domain:

$$s_1(t) = g\big(|s(t)|\big)s(t) \tag{2}$$

where $g$ is the amplifier gain and $|s(t)|$ is the amplitude of the complex input signal $s(t)$. $g$ is a function of the instantaneous amplitude of the input signal $s$. The gain $g$ may modify the amplitude and/or the phase of the input signal $s$ in a non-linear way, introducing nonlinearities into the communication system, be it in the AM-AM characteristics, *i.e.* the curve of the output signal amplitude as a function of the input signal amplitude, and/or the AM-PM characteristics, *i.e.* the curve of the output signal phase as a function of the input signal amplitude.

In the frequency domain, $S_1$ is the result of the convolution between the gain $G$ of the power amplifier and the input signal $S$:

$$S_1(f) = G\big(S(f)\big) \otimes S(f) \tag{3}$$

The amplified signal, $S_1$, is then transmitted by one or more antennas onto the transmission channel 320. The received signal $S_2$ can be expressed as:

$$S_2(f) = H(f)S_1(f) + \eta(f) \tag{4}$$

where $H$ stands for the channel response in the frequency domain and $\eta$ is an additive white gaussian noise.

The channel estimation conventionally obtains frequency response $H(f)$, or the corresponding impulse response $h(t)$ in the time domain. For doing, it may use pilot tones in OFDM symbols or pilot OFDM symbols as defined above.

The non-linearity estimation consists *e.g.* in determining interpolation points of the AM-AM characteristics and/or of the AM-PM characteristics of the power amplifier.

If we denote $x = |s(t)|$, the amplitude of the input signal and assume first that the gain function $g(x)$ is real, it can be expressed as a polynomial:

$$g(x) = g_0 + g_1 x + g_2 x^2 + \ldots + g_{M-1} x^{M-1} \tag{5}$$

where the coefficients $g_0,\ldots,g_{M-1}$ can be obtained by a training sequence $P_0,\ldots,P_{N-1}$.

$g_0$ being the linear gain of the power amplifier the actual gain can equivalently be expressed as:

$$g(x) = g_0 g_{NL}(x) \tag{6}$$

where $g_{NL}(x)$ is also a polynomial of degree $M$-1.

We assume now, that $s(t)$ represents a training sequence in the time domain. In practice this sequence is defined as a series of samples, the respective amplitudes and phases of which are known to the receiver.

Advantageously, the non-linear function $g_{NL}(x)$ is projected onto an orthonormal base of polynomials $p_0(x)$, $p_1(x),\ldots, p_{M-1}(x)$, which spans an hyperplane of dimension $M$. In other words, the non-linear gain function can be approximated as follows:

$$g_{NL}(x) = \alpha_0 p_0(x) + \alpha_1 p_1(x) + ... + \alpha_{M-1} p_{M-1}(x) \tag{7}$$

where $\langle p_m, p_{m'} \rangle = \delta_{m,m'}$, $\delta_{m,m'}$ being the Kronecker symbol and $\alpha_m = \langle g_{NL}, p_m \rangle$.

The dot product between two polynomials $f$ and $g$ is defined here as:

$$\langle f, g \rangle = \int_{[0,T]} f(|s(t)|) g(|s(t)|) dt \tag{8}$$

where $[0,T]$ is the time interval on which the training sequence is defined. The base of polynomials $p_m$, $m = 1,.., M\text{-}1$, can be obtained *e.g.* by the Gram-Schmidt orthonormalization algorithm, as known *per se.* It is important to note that the base of polynomials depends upon the training sequence. In the first variant, *i.e.* where the OFDM training symbols are known *a priori,* the coefficients of the polynomials can be pre-computed off-line and stored in a look-up table at the receiver side.

If we denote $y(t)$ the received signal in the time domain corresponding to the transmission of the training sequence, the non-linear characteristics can be obtained by projecting the amplitude of the received signal onto the orthonormal polynomials, namely by calculating the coefficients from the dot product:

$$\alpha_m = \int_{[0,T]} |\tilde{y}(t)| \, p_m(|s(t)|) dt \tag{9}$$

where $\tilde{y}(t)$ is the equalized received signal. Alternatively, the coefficients may be calculated from the received signal, before equalization:

$$\alpha'_m = \int |y(t)| \, p_m(|s(t)|) dt \tag{10}$$

It should be noted that these coefficients take into account both the linear effect due to the channel (fading coefficients) and the non-linear effect incurred upstream.

More generally, the gain function is complex and can be approximated as follows:

$$g_{NL}(x) = \alpha_0 p_0(x) + \alpha_1 p_1(x) + ... + \alpha_{M-1} p_{M-1}(x) \exp\left(j\left(\beta_0 p_0(x) + \beta_1 p_1(x) + ... + \beta_{M-1} p_{M-1}(x)\right)\right) \tag{11}$$

where $\beta_m = \langle \arg(g_{NL}, p_m) \rangle$.

The coefficients $\alpha_m$ and $\beta_m$ can be estimated and sent to the transmitter. More specifically, the phase of the received signal $\arg(y(t))$ (equalized or not) is projected onto the set of polynomials $p(s(t))$ similar to (10). The amplitude predistortion function $f(x) = g_{NL}^{-1}(|x|)$ may be calculated at the transmitter side. Amplitude predistortion is applied at the input of the power amplifier and phase compensation is performed at the output thereof by multiplying the amplified signal with the coefficient $\exp(-\arg(g_{NL}(x)))$.

Instead of defining the non-linear function $g_{NL}(x)$ by a plurality of polynomial coefficients, it may alternatively be defined by plurality $N$ of points of coordinates $(a_i, b_i \exp(jd_i))$ where $b_i \exp(jd_i) = g_{NL}(a_i)$. In such instance, the predistortion function $f(x)$ can be obtained as a sum of Lagrange polynomials:

$$f(x) = \sum_{i=1}^{N} L_i(x) \quad \text{where} \quad L_i(x) = a_i \prod_{j \neq i} \frac{x - b_j}{b_i - b_j} \tag{12}$$

It should be understood that $f$ is an interpolation polynomial of degree $N$-1 such that $f(b_i) = a_i$ for $i = 1,..., N$. In such instance, the coordinates $(a_i,b_i\exp(jd_i))$ are sent to the transmitter. As above, the complex coefficients $\exp(jd_i)$ are used to multiply the amplified signal so as to rectify the phase distortion introduced by the power amplifier.

By applying the amplitude predistortion to the input signal, the amplified signal at the output of the power amplifier is:

$$s_1(t) = g\big(f\big(|s(t)|\big)\big)s(t) = g_0 s(t)\exp(j\arg(g_{NL}(s(t)))) \tag{13}$$

and, after phase compensation by multiplication with $\exp(-j\arg(g_{NL}(s(t))))$ :

$$\bar{s}_1(t) = g_0 s(t) \tag{14}$$

More generally, it will be understood that the amplitude predistortion applied at the transmitter side can account for any non-linear effect affecting the amplitude of the signal downstream (*i.e.* not only the power amplifier). Similarly, phase compensation may be combined with phase predistortion to remove a non-linear effect affecting the phase of the signal downstream.

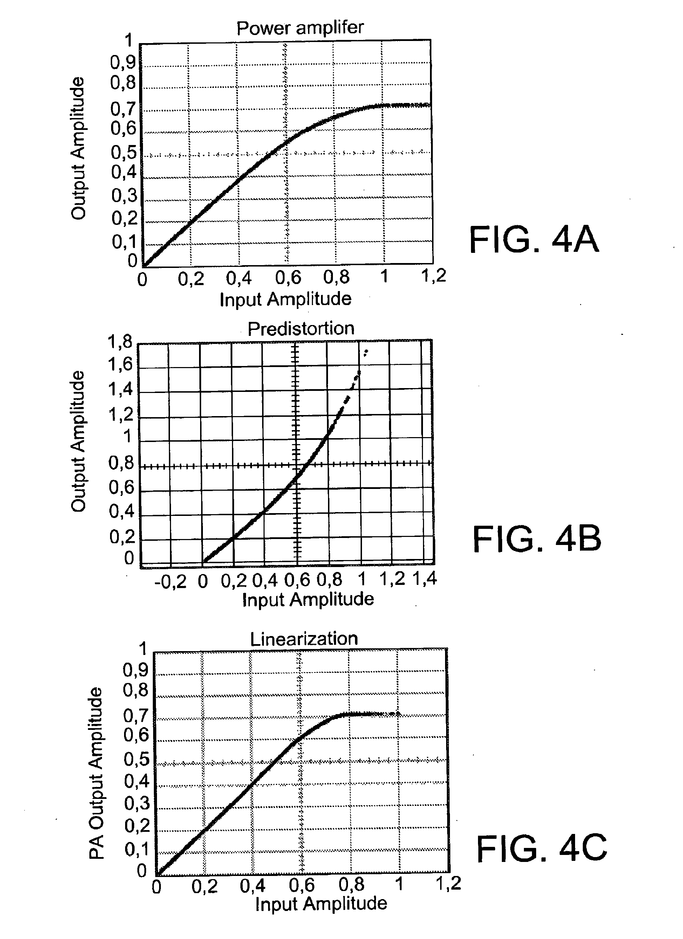

Fig. 4A illustrates the AM-AM characteristics of a non-linear amplifier, e.g. the characteristics of the power amplifier in Fig. 1. It is noted that the amplifier saturates when the normalized amplitude of the input signal $na$ is larger than 1.

The amplitude compensation used in the prior art allows to compensate for the non-linear effect when $na$ is lower than 1. However, for $na > 1$, the amplitude information is lost. By contrast, it is possible to choose the predistortion function so that the predistorted signal remains in the unsaturated region.

Fig. 4B illustrates an example of predistortion function to be applied at the input of the amplifier.

Fig. 4C illustrates the characteristics of the power amplifier linearized by the predistortion function.

As already mentioned above, the predistortion information, in the form *e.g.* of the weighting coefficients $\alpha_0,...,\alpha_{M-1}$ or the coordinates of the interpolation points $(a_i,b_i)$, are sent to the transmitter.

More generally the predistortion information contains a list of parameters describing the non-linear effect $g_{NL}$ or its inverse, $g_{NL}^{-1}$.

This predistortion information can be included in already existing messages if the telecommunication standard of the system provides for a return channel, and if sufficient bits are left available in these messages. Alternatively, new messages dedicated to the predistortion information can be created.

Two examples of using existing messages will be given hereinafter.

The WiMAX 802.16e standard provides for a mechanism allowing a base station (BS) to schedule a feedback from a mobile station (MS). For so doing the BS sends a message "Feedback Polling IE" (IE: Information Element) to the MS. The MS replies by sending back a message "Feedback header". The MS may also send this message as unsolicited feedback. A detailed presentation of the standard IEEE 802.16e is available from the URL http://standards.ieee.org.

The BS requests the MS to perform an estimation of the nonlinear effect by sending a specific message "Feedback Polling IE" *e.g.* with a "Feedback type" having a value larger than 14 (1110b).

Upon receiving such a message, the MS estimates the parameters describing the non-linear and sends the predistortion information to the BS via a "Feedback header" message.

The BS uses the predistortion information to predistort the signal before transmission over the downlink transmission channel.

The 3GPP project LTE (Long Term Evolution) as described in the specification 3GG TS 36.212 V9.0.0 downloadable from the 3GPP website http://www.3gpp.org provides the possibility for the base station (resp. the mobile station) to request the channel quality information of downlink (resp. uplink) channel by sending a DCI (downlink control information) message.

By adding a new format of the DCI message dedicated to non-linear estimation, the BS (resp. the MS) may request from the MS (resp. the BS) to estimate the parameters describing the non-linear effect. The predistortion information thus obtained can be sent over the feedback channel as a feedback message, for example as part of a HARQ-ACK message.

The man skilled in the art will understand that the present invention is not restricted to the above-described embodiments and examples and that, on the contrary, further embodiments can be contemplated within the scope of the claims appended hereto.

**Claims**

1. Method for mitigating a nonlinear effect affecting an OFDM communication system, which includes a transmitter, a transmission channel and a receiver, comprising:

    - estimating at the receiver a set of parameters describing said nonlinear effect, from a sequence received at the receiver and distorted by said nonlinear effect;
    - transmitting the estimated values of said parameters back to said transmitter over a return channel;
    - predistorting at the transmitter a signal to be sent to the receiver by using said estimated values of said parameters,

    the method being **characterized in that** said sequence is a training sequence, which training sequence is constituted by a plurality of training symbols $\lambda_0 P_0, \lambda_1 P_0, ..., \lambda_{N-1} P_0$, where $P_0$ is an OFDM pilot symbol and $\lambda_0,..., \lambda_{N-1}$ are scalar or complex value having distinct amplitudes.

2. Method according to claim 1, whereby $\lambda_n = a^n e^{i\varphi_n}$ for $0 \leq n \leq N-1$ where $a>1$ is a scalar value, $\varphi_n$ are phase values.

3. Method according to any of claims 1 or 2, whereby the set of parameters comprises a plurality $M$ of first coefficients $\alpha_0,...,\alpha_{M-1}$ such that:

$$g_{NL}(x) = \alpha_0 p_0(x) + \alpha_1 p_1(x) + ... + \alpha_{M-1} p_{M-1}(x)$$

    where $g_{NL}(x)$ is a real function describing the nonlinear effect in relation with the amplitude $x$ of the signal and $p_0(x),..., p_{M-1}(x)$ is a plurality $M$ of orthonormal polynomials.

4. Method according to claim 3, whereby said each first coefficient ($\alpha_m$) related to a polynomial ($p_m$) is obtained by calculating a dot product between a signal representing the training sequence, distorted by said polynomial, and the signal actually received by the receiver when said sequence is transmitted ($y(t)$).

5. Method according to claim 3 or 4, whereby the predistortion of a signal $s(t)$ is carried out at the transmitter by multiplying said signal with $g_{NL}^{-1}(|s(t)|)$ prior to the occurrence of said non-linear effect.

6. Method according to any claims 1 or 2, whereby the set of parameters comprises a plurality $M$ of first coefficients $\alpha_0,...,\alpha_{M-1}$, and a same plurality of second coefficents $\beta_0,...,\beta_{M-1}$ calculated so that:

$$g_{NL}(x) = [\alpha_0 p_0(x) + ... + \alpha_{M-1} p_{M-1}(x)] \times \exp(j[\beta_0 p_0(x) + ... + \beta_{M-1} p_{M-1}(x)])$$

    where $g_{NL}$ is a complex function describing the nonlinear effect in relation with the amplitude $x$ of the signal and

$p_0(x),...,p_{M-1}(x)$ is a plurality **M** of orthonormal polynomials.

7.  Method according to claim 6, whereby the predistortion of a signal **s(t)** is carried out at the transmitter by multiplying said signal with $g_{NL}^{-1}\big(|s(t)|\big)$ prior to the occurrence of said non-linear effect and by multiplying thereafter the signal with a phase compensation term **exp(-j[β₀p₀(x)+...+ β_{M-1}p_{M-1}(x)]).**

8.  Method according to any of claims 1 or 2, whereby the set of parameters comprises the coordinates of interpolation points of **g_{NL}(x)** or its inverse **g_{NL}(x)**, where **g_{NL}(x)** is a function describing the nonlinear effect in relation with the amplitude **x** of the signal.

9.  Method according to any preceding claim, whereby the communication system is in conformity with the Wi-MAX 802.16e standard and that an estimation of the nonlinear effect is requested from a base station to a mobile station by sending thereto a "Feedback Polling IE" message with a "Feedback type" having a value larger than 14, i.e. 1110b in binary form.

10. Method according to claim 9, whereby the mobile station sends the predistortion parameters to the base station in a "Feedback header" message.

11. Method according to any of claims 1 to 8, whereby the communication system is in conformity with the 3GG TS 36.212 specification and that a base station or a mobile station requests from a mobile station or a base station respectively, an estimation of the non-linear effect by sending thereto a DCI message.

12. Method according to claim 11, whereby the mobile station or the base station sends the predistortion parameters in a feedback message.

13. Method according to claim 12, whereby the feedback message is an HARQ-ACK message.


**Patentansprüche**

1.  Verfahren zum Abschwächen eines nichtlinearen Effekts, welcher ein OFDM-Kommunikationssystem beeinträchtigt, das einen Sender, einen Sendekanal und einen Empfänger umfasst, welches umfasst:

    - Schätzen eines Satzes von Parametern am Empfänger, die den nichtlinearen Effekt beschreiben, aus einer an dem Empfänger empfangenen und durch den nichtlinearen Effekt verzerrten Sequenz;
    - Übertragung der Schätzwerte der Parameter zurück zu dem Sender über einen Rückkanal;
    - Vorverzerrung eines Signals am Sender, das an den Empfänger mittels der geschätzten Werte der Parameter gesendet werden soll,

    wobei das Verfahren **dadurch gekennzeichnet ist, dass** die Sequenz eine Trainingssequenz ist, wobei die Trainingssequenz aus einer Vielzahl von Trainingssymbolen $\lambda_0 P_0, \lambda_1 P_0,..., \lambda_{N-1}P_0$, besteht, wo $P_0$ ein OFDM-Pilotsymbol und $\lambda_0,..., \lambda_{N-1}$ skalare oder komplexe Werte mit abgegrenzten Amplituden sind.

2.  Verfahren nach Anspruch 1, wobei $\lambda_n = a^n e^{i\varphi_n}$ für $0 \le n \le N-1$ wo $a > 1$ ein skalarer Wert ist, $\varphi_n$ Phasenwerte sind.

3.  Verfahren nach einem der Ansprüche 1 oder 2, wobei der Satz von Parametern eine Vielzahl M von ersten Koeffizienten $\alpha_0,...,\alpha_{M-1}$ derart aufweist:

$$g_{NL}(x) = \alpha_0 p_0(x) + \alpha_1 p_1(x) + ... + \alpha_{M-1} p_{M-1}(x)$$

    wobei $g_{NL}(x)$ eine reelle Funktion ist, die den nichtlinearen Effekt im Verhältnis zu der Amplitude x des Signals beschreibt, und $p_0(x),..., p_{M-1}(x)$ eine Vielzahl M von orthonormalen Polynomen ist.

4.  Verfahren nach Anspruch 3, wobei jeder erste Koeffizient ($\alpha_m$), der im Verhältnis zu einem Polynom ($p_m$) steht, durch Berechnen eines Punktprodukts zwischen einem Signal, das die Trainingssequenz, verzerrt durch das Polynom, darstellt, und dem Signal, das tatsächlich durch den Empfänger empfangen wird, wenn die Sequenz übertragen wird (*y*(*t*)), erhalten wird.

5. Verfahren nach Anspruch 3 oder 4, wobei die Vorverzerrung eines Signals *s*(*t*) am Sender durch Multiplizieren des Signals mit $g_{NL}^{-1}\left(|s(t)|\right)$ vor dem Auftreten des nichtlinearen Effekts durchgeführt wird.

6. Verfahren nach einem der Ansprüche 1 oder 2, wobei der Satz von Parametern eine Vielzahl *M* von ersten Koeffizienten $\alpha_0,...,\alpha_{M-1}$, und eine gleiche Vielzahl von zweiten Koeffizienten $\beta_0,...,\beta_{M-1}$ aufweist, derart berechnet:

$$g_{NL}(x) = \left[\alpha_0 p_0(x) + ... + \alpha_{M-1} p_{M-1}(x)\right] \\ \times \exp\left(j\left[\beta_0 p_0(x) + ... + \beta_{M-1} p_{M-1}(x)\right]\right)$$

wobei $g_{NL}$ eine komplexe Funktion ist, die den nichtlinearen Effekt im Verhältnis zu der Amplitude *x* des Signals beschreibt, und $p_0(x),..., p_{M-1}(x)$ eine Vielzahl *M* von orthonormalen Polynomen ist.

7. Verfahren nach Anspruch 6, wobei die Vorverzerrung eines Signals *s*(*t*) am Sender durch Multiplizieren des Signals mit $g_{NL}^{-1}\left(|s(t)|\right)$ vor dem Auftreten des nichtlinearen Effekts und durch anschließendes Multiplizieren des Signals mit einem Phasenkompensationsterm $\exp(-j[\beta_0 p_0(x) + ... + \beta_{M-1} p_{M-1}(x)])$ durchgeführt wird.

8. Verfahren nach einem der Ansprüche 1 oder 2, wobei der Satz von Parametern die Koordinaten der Interpolationspunkte von $g_{NL}(x)$ oder ihrer Umkehrfunktion $g_{NL}(x)$ aufweist, wobei $g_{NL}(x)$ eine Funktion ist, die den nichtlinearen Effekt im Verhältnis zu der Amplitude *x* des Signals beschreibt.

9. Verfahren nach einem der vorhergehenden Ansprüche, wobei das Kommunikationssystem mit dem Wi-MAX 802.16e Standard konform ist, und eine Schätzung des nichtlinearen Effekts durch eine Basisstation von einer Mobilstation durch Senden einer "Feedback Polling IE"-Nachricht an diese mit einem "Feedback type", welcher einen Wert von größer als 14, das heißt 1110b in Binärform hat, angefordert wird.

10. Verfahren nach Anspruch 9, wobei die Mobilstation die Vorverzerrungsparameter an die Basisstation in einer "Feedback Header "-Nachricht sendet.

11. Verfahren nach einem der Ansprüche 1 bis 8, wobei das Kommunikationssystem mit der 3GG TS 36.212 Spezifikation konform ist und eine Basisstation oder eine Mobilstation von einer Mobilstation oder einer Basisstation jeweils entsprechend eine Schätzung des nichtlinearen Effekts anfordert, indem sie dazu eine DCI-Nachricht an diese sendet.

12. Verfahren nach Anspruch 11, wobei die Mobilstation oder die Basisstation die Vorverzerrungsparameter in einer Feedbacknachricht sendet.

13. Verfahren nach Anspruch 12, wobei die Feedbacknachricht eine HARQ-ACK Nachricht ist.

**Revendications**

1. Procédé d'atténuation d'un effet non linéaire affectant un système de communication OFDM, qui comporte un émetteur, un canal d'émission et un récepteur, comprenant les étapes consistant à :

- estimer sur le récepteur un jeu de paramètres décrivant ledit effet non linéaire à partir d'une séquence reçue sur le récepteur et déformée par ledit effet non linéaire ;
- retransmettre les valeurs estimées desdits paramètres audit émetteur via un canal de retour ;
- pré-déformer sur l'émetteur un signal à envoyer au récepteur en utilisant lesdites valeurs estimées desdits paramètres,

le procédé étant **caractérisé en ce que** ladite séquence est une séquence de formation, laquelle séquence de formation est constituée d'une pluralité de symboles de formation $\lambda_0 P_0, \lambda_1 P_0, ..., \lambda_{N-1} P_0$, où $P_0$ est un symbole pilote OFDM et $\lambda_0, ..., \lambda_{N-1}$ sont une valeur scalaire ou complexe ayant des amplitudes distinctes.

2. Procédé selon la revendication 1, dans lequel $\lambda_n = a^n e^{i\varphi n}$ pour $0 \leq n \leq N\text{-}1$, où $a > 1$ est une valeur scalaire et $\varphi_n$ sont des valeurs de phases.

3. Procédé selon l'une quelconque des revendications 1 ou 2, dans lequel le jeu de paramètres comprend une pluralité $M$ de premiers coefficients $\alpha_0, ..., \alpha_{M-1}$ tels que :

$$g_{NL}(x) = \alpha_0 p_0(x) + \alpha_1 p_1(x) + ... + \alpha_{M-1} p_{M-1}(x)$$

où $g_{NL}(x)$ est une fonction réelle décrivant l'effet non linéaire en rapport avec l'amplitude $x$ du signal et $p_0(x), ..., p_{M-1}(x)$ est une pluralité $M$ de polynômes orthonormés.

4. Procédé selon la revendication 3, dans lequel chacun desdits premiers coefficients ($\alpha_m$) rapporté à un polynôme ($p_m$) est obtenu en calculant un produit scalaire entre un signal représentant la séquence de formation, déformé par ledit polynôme, et le signal réellement reçu par le récepteur lorsque ladite séquence est transmise ($y(t)$).

5. Procédé selon la revendication 3 ou la revendication 4, dans lequel la pré-distorsion d'un signal $s(t)$ est effectuée sur l'émetteur en multipliant ledit signal par $g_{NL}^{-1}\left(\left|s(t)\right|\right)$ avant la manifestation dudit effet non linéaire.

6. Procédé selon l'une quelconque des revendications 1 ou 2, dans lequel le jeu de paramètres comprend une pluralité $M$ de premiers coefficients $\alpha_0, ..., \alpha_{M-1}$ et une même pluralité de seconds coefficients $\beta_0, ..., \beta_{M-1}$ calculés de sorte que :

$$g_{NL}(x) = [\alpha_0 p_0(x) + ... + \alpha_{M-1} p_{M-1}(x)]$$
$$x \, \exp(j[\beta_0 p_0(x) + ... + \beta_{M-1} p_{M-1}(x)])$$

où $g_{NL}$ est une fonction complexe décrivant l'effet non linéaire en rapport avec l'amplitude $x$ du signal et $p_0(x), ..., p_{M-1}(x)$ est une pluralité $M$ de polynômes orthonormés.

7. Procédé selon la revendication 6, dans lequel la pré-distorsion d'un signal $s(t)$ est effectuée sur l'émetteur en multipliant ledit signal par $g_{NL}^{-1}\left(\left|s(t)\right|\right)$ avant la manifestation dudit effet non linéaire et en multipliant ensuite le signal par un terme de compensation de phase $\exp(-j[\beta_0 p_0(x) + ... + \beta_{M-1} p_{M-1}(x)])$.

8. Procédé selon l'une quelconque des revendications 1 ou 2, dans lequel le jeu de paramètres comprend les coordonnées de points d'interpolation de $g_{NL}(x)$ ou de son inverse $g_{NL}^{-1}(x)$, où $g_{NL}(x)$ est une fonction décrivant l'effet non linéaire en rapport avec l'amplitude $x$ du signal.

9. Procédé selon l'une quelconque des revendications précédentes, dans lequel le système de communication est en conformité avec la norme WiMAX 802.16e et une estimation de l'effet non linéaire est demandée par une station de base à une station mobile en lui envoyant un message « Feedback Polling IE » avec un « Feedback Type» ayant une valeur supérieure à 14, c'est-à-dire 1110b sous forme binaire.

10. Procédé selon la revendication 9, dans lequel la station mobile envoie les paramètres de pré-distorsion à la station de base dans un message « Feedback Header».

**11.** Procédé selon l'une quelconque des revendications 1 à 8, dans lequel le système de communication est en conformité avec la spécification 3GG TS 36.212 et une station de base ou une station mobile demande à une station mobile ou à une station de base, respectivement, une estimation de l'effet non linéaire en lui envoyant un message DCI.

**12.** Procédé selon la revendication 11, dans lequel la station mobile ou la station de base envoie les paramètres de pré-distorsion dans un message de rétroaction.

**13.** Procédé selon la revendication 12, dans lequel le message de rétroaction est un message HARQ-ACK.

FIG. 1

FIG. 2

FIG. 3

Power amplifer

FIG. 4A

Predistortion

FIG. 4B

Linearization

FIG. 4C

**EP 2 599 274 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6304140 A
- US 20080032631 A

- EP 2117115 A